# EUROPÄISCHE PATENTSCHRIFT

(11) **EP 2 561 417 B1**
(45) Veröffentlichungstag und Bekanntmachung des Hinweises auf die Patenterteilung: **14.01.2015**
(21) Anmeldenummer: 11712521.1
(22) Anmeldetag: 30.03.2011
(51) Int. Cl.: G06F 17/50, G06T 19/00, G05B 19/418

(54) **VERFAHREN ZUR EINGABE EINES RÄUMLICHEN AUFBAUS VON FERTIGUNGSEINRICHTUNGEN IN EIN RECHNERGESTÜTZTES PLANUNGSPROGRAMM UND DESSEN OPTIMIERUNG**
METHOD FOR INPUTTING A SPATIAL STRUCTURE OF PRODUCTION DEVICES TO A COMPUTER-AIDED PLANNING PROGRAM AND FOR OPTIMIZING THE LATTER
PROCÉDÉ POUR INTRODUIRE UNE CONFIGURATION SPATIALE DE DISPOSITIFS DE FABRICATION DANS UN PROGRAMME DE PLANIFICATION ASSISTÉ PAR ORDINATEUR ET SON OPTIMISATION

(30) Priorität: 23.04.2010 DE 102010018634
(43) Veröffentlichungstag der Anmeldung: 27.02.2013
(73) Patentinhaber: Siemens Aktiengesellschaft, 80333 München (DE)
(72) Erfinder: UZELAC, Sanja, 80797 München (DE); MÜLLER, Martin C, 81737 München (DE)
(86) Internationale Anmeldenummer: PCT/EP2011/054880
(87) Internationale Veröffentlichungsnummer: WO 2011/131459

(56) Entgegenhaltungen:
- EP-A2- 0 685 804
- US-A- 4 700 317
- US-A1- 2002 107 674

## Beschreibung

Die Erfindung betrifft ein Verfahren zur Eingabe eines räumlichen Aufbaus von Fertigungseinrichtungen, die zusammen eine Fertigungsstätte bilden, in ein rechnergestütztes Planungsprogramm und dessen Optimierung. Bei dem Verfahren werden von den Fertigungseinrichtungen, die z. B. aus Bearbeitungsmaschinen für ein Produkt bestehen können, zweidimensionale oder dreidimensionale maßstabgerechte Modelle erzeugt, die zumindest hinsichtlich ihres körperlichen Flächenbedarfs mit den Originalen übereinstimmen. Mit diesen wird ein Modellaufbau der Fertigungsstätte auf einer flächigen Unterlage hergestellt. Anschließend wird der Modellaufbau mit einem Sensor erfasst, wobei vorzugsweise ein Bildsensor, z. B. eine CCD-Kamera zum Einsatz kommt. Dann wird die Position der Modelle auf der Grundlage der durch den Sensor erfassten Daten durch das Planungsprogramm berechnet und mit Datensätzen der Fertigungseinrichtungen in dem Planungsprogramm verknüpft. Die Erkennung der Modelle kann dabei beispielsweise durch eine geeignete Bildverarbeitung mit einem anschließenden Mustervergleich erfolgen.

Als Fertigungsstätte soll im weiteren Sinne ein Gebilde verstanden werden, was aus mindestens zwei Fertigungseinrichtungen besteht. Hiermit kann beispielsweise eine Fertigungszelle gemeint werden, die mehrere Maschinen enthält. Es kann als Fertigungsstätte jedoch auch beispielsweise eine ganze Fabrikhalle oder sogar eine gesamte Fabrik als Modell dargestellt werden. Als Fertigungseinrichtungen sind im weiteren Sinne alle für die Fertigung erforderlichen räumlichen Einheiten zu verstehen. Hierzu gehören im engeren Sinne Maschinen zur Bearbeitung von Produkten, jedoch gleichfalls Einrichtungen zum Transport der Produkte zwischen den unterschiedlichen Maschinen sowie weitere in der Fertigungsstätte notwendige räumliche Einrichtungen. Unter sonstige räumliche Einrichtungen können beispielsweise Büros für Fertigungsleiter, Laufwege für Mitarbeiter, Lagerflächen für Material usw. verstanden werden.

An sich ist es allgemein bekannt, Fertigungsstätten wie beispielsweise Fabrikhallen als Modell darzustellen. Derartige Modelle können insbesondere in der Planungsphase das Vorstellungsvermögen der an der Planung Beteiligten unterstützen.

Als Alternative bieten sich rechnergestützte Planungswerkzeuge für die Fabrikplanung an, wie diese beispielsweise in einem Firmenprospekt von 2008 durch die Firma Fujitsu unter dem Handelsnamen GLOVIA angeboten werden. Diese rechnergestützten Planungstools erfordern die Eingabe von virtuellen dreidimensionalen Modellen der Fertigungseinrichtungen sowie der räumlichen Gegebenheiten der Fertigungsstätte. Anschließend können die so erzeugten Modelle in einer virtuellen Umgebung zusammengestellt werden und ein Fertigungsablauf simuliert werden, um Rückschlüsse auf die Funktionstauglichkeit der geplanten Fertigungsstätte ziehen zu können.

Sowohl mittels realer Modellaufbauten als auch mittels rechnergestützter Simulationen von Fertigungsstätten können Optimierungsprozesse durchgeführt werden, die vor einem Aufbau der Fertigungsstätte eine Optimierung der Fertigungsabläufe sowie des Raumbedarfs und weiterer Aspekte zulassen. Hierbei haben reale Modellaufbauten den Vorteil, dass eine intuitive Schnittstelle für den Fabrikplaner besteht. Andererseits haben rechnergestützte Planungsprogramme den Vorteil, dass eine Simulation des Fertigungsablaufes leichter fällt und bei der Modellbildung neben räumlichen Daten auch weitere Daten verarbeitet werden können.

Um in dem oben beschriebenen Planungsprogramm eine Simulation der Fertigungsstätte aufbauen zu können, müssen nämlich die Rahmenbedingungen für den jeweiligen zu planenden Anwendungsfall bekannt sein. Hierzu gehören die räumlichen Gegebenheiten der Fertigungsstätte, die bereits vorhanden sein kann (Optimierungsaufgabe) oder noch gebaut werden muss (Planungsaufgabe), und die Eigenschaften der zur Anwendung kommenden Fertigungseinrichtungen. Die Daten können bereits in Datenbanken vorliegen, so dass eine Verknüpfung mit dem Planungsprogramm vergleichsweise einfach durchgeführt werden kann. Allerdings müssen Daten, die noch nicht zur Verfügung stehen, in das Planungsprogramm eingegeben werden, wodurch für den Fabrikplaner ein Aufwand entsteht.

Um den Aufwand der Eingabe der Daten in das Planungssystem zu erleichtern, wird gemäß der US 2002/0107674 A1 vorgeschlagen, dass die Modelle der Fertigungseinrichtungen beispielsweise mit zweidimensionalen Markern versehen werden können, die zur Erkennung der einzelnen Modelle geeignet sind. Mit Hilfe dieser Marker kann beispielsweise durch ein optisches Erkennungssystem die Identität der einzelnen Fertigungseinrichtungen erkannt werden. Weiterhin ist es möglich, deren Ausrichtung zu erkennen. Mittels eines größeren Rechenaufwandes kann auch das Modell selbst als Marker eingesetzt werden, wobei dieses durch geeignete optische Erkennungsverfahren erkannt werden muss.

Gemäß der US 4,700,317 ist ein Programm für eine Layoutplanung, beispielsweise von Fabriken, beschrieben, bei dem neben dem tatsächlichen Flächenbedarf der Fertigungseinrichtungen auch ein größerer, relevanter Flächenbedarf berücksichtigt werden kann. Dieser wird durch das Programm automatisch identifiziert und bei der Generierung eines Vorschlags für das Layout berücksichtigt. Nachdem der den relevanten Flächenbedarf der Fertigungseinrichtungen berücksichtigende Vorschlag erarbeitet wurde, wird der Vorschlag an einer geeigneten Ausgabeeinrichtung ausgegeben. Dort wird der Flächenbedarf der einzelnen Fertigungseinrichtungen dargestellt, wobei Fertigungseinrichtungen, deren relevanter Flächenbedarf größer ist, einen entsprechend größeren Abstand zu benachbarten Fertigungseinrichtungen aufweisen. In welcher Weise die Berücksichtigung eines relevanten Flächenbedarfs einzelner Fertigungseinrichtungen im Einzelnen in das vorgeschlagene Planungsergebnis eingeflossen sind, lässt sich der Ausgabe nicht entnehmen.

Die Aufgabe der Erfindung besteht darin, ein Verfahren zur Eingabe des Zusammenspiels von Fertigungseinrichtungen einer Fertigungsstätte in ein rechnergestütztes Planungsprogramm anzugeben, wobei das Verfahren zur Eingabe nachfolgende Optimierungsschritte vergleichsweise rationell ermöglichen soll.

Diese Aufgabe wird mit dem eingangs angegebenen Verfahren erfindungsgemäß durch folgende Maßnahmen gelöst. Die Datensätze der Fertigungseinrichtungen weisen auch Daten zum relevanten Flächenbedarf der Fertigungseinrichtungen auf, wobei der relevante Flächenbedarf über den körperlichen Flächenbedarf hinausgeht. Ein relevanter Flächenbedarf bestimmter Fertigungseinrichtungen kann aus unterschiedlichen Gründen den tatsächlichen (räumlichen) Flächenbedarf dieser Fertigungseinrichtungen übersteigen. Beispielsweise muss eine Zugänglichkeit durch Personal gewährleistet sein, so dass zwischen zwei Fertigungseinrichtungen ein gewisser Abstand eingehalten werden muss. Außerdem kann auch das zu bearbeitende Werkstück einen Raumbedarf aufweisen, der bei der Aufstellung der Fertigungseinrichtungen berücksichtigt werden muss. Es muss nämlich gewährleistet werden, dass die Bereitstellung des Werkstücks beispielsweise durch ein Bereitstellungssystem möglich ist. Auch sind andere Gründe denkbar, weswegen der tatsächliche Flächenbedarf der Fertigungseinrichtung größer ist (beispielsweise Wartungsklappen).

Bei dem erfindungsgemäßen Verfahren ist weiterhin vorgesehen, dass Überlappungen des jeweiligen relevanten Flächenbedarfs benachbarter Fertigungseinrichtungen ermittelt werden. Anschließend werden diese Überlappungen über ein Ausgabegerät angezeigt. Die Anzeige dieser Überlappungen kann auf unterschiedliche Weise erfolgen. Beispielsweise kann um die Fertigungseinrichtungen herum der relevante Flächenbedarf durch eine geeignet eingefärbte Fläche dargestellt werden. Überlappungen sind dann als Schnittflächen zwischen benachbarten tatsächlichen Flächenbedarfskennzeichnungen zu erkennen. Überlappungen können aber auch dadurch angezeigt werden, dass im Bereich der Überlappungen das Ausgabegerät ein Gefahrensymbole oder Pfeile als Vorschläge, wie Überlappungen vermieden werden können, dargestellt werden.

Mit dem erfindungsgemäßen Verfahren ist daher auf eine vergleichsweise effektive Weise eine Korrektur von fehlerhaften Fabrikplanungsprozessen im dreidimensionalen Modell möglich. Die intuitive Eingabe der Fabrikplaner durch Stellen der Modelle erzeugt als Ausgabe sozusagen ein Feedback eines rechnergestützten Fabrikplanungssystems, welches unter Berücksichtigung geeigneter Datensätze sofort Kollisionen zwischen dem relevanten Flächenbedarf einzelner Fertigungseinrichtungen ermitteln kann. Der Fabrikplanungsprozess ist somit als Dialog zwischen den menschlichen Planern am Planungstisch und dem das Ausgabegerät nutzenden Fabrikplanungsprogramm (kurz auch als Planungsprogramm bezeichnet) zu verstehen. Hierdurch lässt sich vorteilhaft ein großer Rationalisierungseffekt bei gleichzeitig intuitivem Eingabeverfahren erzeugen.

Gemäß einer Ausgestaltung der Erfindung ist vorgesehen, dass die Datensätze der Fertigungseinrichtungen weitere Vorgaben für die Fertigungseinrichtungen, insbesondere Standards und Richtlinien, enthalten. Dies ermöglicht dem Fabrikplanungsprogramm vorteilhaft, dass nicht nur Kollisionen hinsichtlich des Flächenbedarfs Berücksichtigung finden können, sondern auch Vorgaben, die sich an sich in der Aufteilung der Fabrikhalle nicht darstellen lassen. Beispielsweise könnte berücksichtigt werden, dass in einer Fertigungseinrichtung zur Lackierung von Werkstücken eine Geruchsbelästigung auftritt, so dass Fertigungseinrichtungen, die durch Menschen betrieben werden, nicht in der Nähe dieser lackierenden Fertigungseinrichtung stehen. Standards und Richtlinien, die als weitere Vorgaben in den Datensätzen Berücksichtigung finden, könnten beispielsweise Sicherheitsabstände bei Gefahrgut oder ähnliches sein. Durch Berücksichtigung dieser zusätzlichen Informationen wird die Rationalität des erfindungsgemäßen Verfahrens vorteilhaft weiter gesteigert.

Eine Weiterbildung der Erfindung sieht vor, dass weitere Datensätze in dem Planungsprogramm vorgesehen sind, die die Beziehungen der Fertigungseinrichtungen untereinander, insbesondere Stoffflüsse und Transportwege, betreffen. Es handelt sich bei den weiteren Datensätzen, die im Folgenden auch immer konkret als "weitere Datensätze" bezeichnet werden, also um Daten, die nicht direkt mit den Fertigungseinrichtungen verknüpft sind und daher in den weiteren Datensätzen abgelegt werden. Weiterhin gibt es im Folgenden konkret als "zusätzliche Datensätze" bezeichnete zusätzliche Datensätze, die die baulichen Gegebenheiten der Fertigungsstätte (Stützpfeiler usw. Höhe der Fertigungshalle, Montagekräne, Türen, Fenster us.) betreffen. Hinsichtlich der Stoffflüsse und Transportwege in den weiteren Datensätzen ist beispielsweise zu bemerken, dass in der Fertigungsstätte Wege zum Transport von Material und zum Erreichen der einzelnen Fertigungseinrichtungen durch das Personal vorgesehen werden müssen. Außerdem können in den weiteren Datensätzen Beziehungen abgespeichert werden, die beispielsweise durch einen ungehinderten Materialfluss des Werkstücks oder von Hilfsstoffen vorgegeben sind. Beispielsweise könnte bei einer Fließbandproduktion die Aufreihung der Fertigungseinrichtungen in einer bestimmten Reihenfolge am Fließband erforderlich sein. Diese Beziehungen lassen sich allerdings besser in weiteren Datensätzen ablegen, die nicht fest an eine bestimmte Fertigungseinrichtung gebunden sind. Durch die weiteren Datensätze kann damit das Fabrikplanungsprogramm vorteilhaft noch rationeller auf die Planungsaktionen reagieren, welche durch den Fabrikplaner am Planungstisch vorgenommen werden. Die zusätzlichen Datensätze ermöglichen überdies eine effiziente Berücksichtigung der räumlichen Gegebenheiten der Fertigungsstätte. Transportwege sollten z. B. zu einen Tor der Werkshalle führen.

Besonders vorteilhaft ist es, wenn das Planungsprogramm einen Korrekturvorschlag zur Vermeidung der ermittelten Überlappungen berechnet und der Korrekturvorschlag über das Ausgabegerät angezeigt wird. Indirekt werden mit dem Korrekturvorschlag auch die Überlappungen angezeigt, da durch die vorgenommenen Änderungen auf die zugrunde liegende Ermittlung von Überlappungen durch das Planungsprogramm geschlossen werden kann. Hierbei kommen an sich bekannte Algorithmen zur Optimierung des planerischen Fabrikkonzepts zur Anwendung, welche in verfügbaren Fabrikplanungsprogrammen bereits umgesetzt sind. Optimierungsprobleme der genannten Art sind als sog. 2-dimensionales Packen bekannt und können durch eine Reihe von Ansätzen gelöst werden, zum Beispiel durch eine leichte Variante der in Beasley J E (1985), "An Exact Two-dimensional Non-guillotine Cutting Tree Search Procedure", Operations Research 33(1): 49-64 vorgeschlagenen sog. ILP-Formulierung (ILP steht für Integer Linear Programming, deutsch ganzzahlig-lineare Programmierung). In der Zielfunktion muss dabei lediglich der Abstand der korrigierten von der gemessenen Position jedes einzelnen Objektes als Gewicht eingesetzt werden. Praktisch gelöst kann diese Formulierung dann durch handelsübliche Software werden, wie zum Beispiel "CPLEX" der Firma IBM ILOG oder "XPRESS" der Firma FICO (früher Fair Isaac, früher Dash). Die Rechenzeiten hängen dabei stark von der Zahl an Fertigungseinrichtungen ab. Überschreitet diese eine gewisse Grenze, beispielsweise 100, kann man statt dessen auch lokale Suchheuristiken einsetzen, wie z.B. evolutionäre Algorithmen, ein sog. Simulated Annealing oder auch ein sog. OptLets Framework, das in der DE 10 2005 011 148 A1 beschrieben wird.

Vorteilhaft ist es auch, wenn der Korrekturvorschlag über das Ausgabegerät angezeigt wird, so dass dem intuitiv arbeitenden Fabrikplaner ein Feedback mit einem Verbesserungsvorschlag gegeben wird. Dieser kann den Verbesserungsvorschlag befolgen oder ggf. einen anderen Verbesserungsvorschlag auf dem Planungstisch umsetzen, um zu sehen, ob das Planungsprogramm nach Analyse des alternativen Vorschlags keine weiteren Kollisionen ausgibt. Die Rationalitätssteigerung bei der Generierung von Korrekturvorschlägen liegt also vorteilhaft in einer Beschleunigung des Prozesses, da der intuitiv arbeitende Fabrikplaner dem Vorschlag folgen kann oder hinsichtlich eines alternativen Vorschlages inspiriert wird.

In gleicher Weise kann vorteilhaft das Planungsprogramm auch einen Korrekturvorschlag zur Vermeidung von ungenutzten Leerflächen berechnen und diesen Korrekturvorschlag über das Ausgabegerät anzeigen. Genauso wie Kollisionen verhindert werden müssen, kann ein wettbewerbsfähiges Planungskonzept nur erstellt werden, wenn die Fläche der Fertigungsstätte optimal genutzt wird. In diesem Kontext sind auch ungenutzte Leerflächen zu vermeiden, welche in der gleichen Weise erkannt und analysiert werden können wie Kollisionen (vgl. das zu den Kollisionen Angegebene).

Wie in der eingangs erwähnten US 2002/0107674 A1 beschrieben, kann die automatische Erfassung der Modelle beispielsweise durch eine Bildverarbeitung unter Erkennung der zweidimensionalen oder dreidimensionalen Modelle erfolgen. Um die Modelle leichter automatisiert erfassen zu können, kann vorgesehen werden, dass die Modelle mit maschinell auslesbaren Trägern von Identifikationskennungen versehen sind. Als Träger von Informationen sollen im weiteren Sinne alle physikalischen Einrichtungen verstanden werden, welche maschinell auslesbare Informationen zur Verfügung stellen können. Dies bedeutet, dass zu diesem Träger jeweils eine Möglichkeit zur maschinellen Auslesung durch ein passendes Lesegerät gegeben sein muss. Beispielsweise kann der Träger die Information auf magnetischem Wege speichern, wobei zum Auslesen dieser Informationen ein magnetischer Sensor als Lesegerät in dessen Nähe gebracht werden muss. Eine weitere Möglichkeit ist die Verwendung so genannter RFID-Tags, welche durch ein geeignetes Lesegerät aktiviert werden und die in dem Träger gespeicherten Informationen beispielsweise über eine Funk- oder Infrarotschnittstelle abgeben. Eine andere Möglichkeit ist die Verwendung von akustischen Informationen. Der Träger muss zu diesem Zweck ein akustisches Signal emitieren, welches durch einen akustischen Sensor aufgefangen werden kann.

Zusätzlich kann vorgesehen werden, dass der Träger zusätzlich zu den Identifikationskennungen Lagekennungen aufweist, die Koordinaten der jeweiligen Lage des betreffenden Trägers auf dem betreffenden Modell enthalten. Mit der Identifikationskennung lässt sich nämlich lediglich das Modell über den Träger identifizieren, so dass durch das Einlesen Daten über das Modell zur Verfügung gestellt werden, die in ein Planungsprogramm eingespeist werden können. Soll jedoch auch die Lage des Modells auf dem Plan durch das Bild bestimmt werden, so ist es vorteilhaft, hierzu lediglich die Lage des Informationsträgers zu bestimmen. Dieses ist mit vergleichsweise geringem Rechenaufwand möglich, da dieser lediglich begrenzte Abmessungen aufweist. Ist die Lage des Informationsträgers auf dem zugehörigen Modell bekannt, so kann über die ermittelte Position des Informationsträgers auch auf die Position des Modells auf der Unterlage geschlossen werden. Hierdurch ist vorteilhaft eine einfache Abbildung eines realen Modellaufbaus in einem Planungsprogramm möglich.

Vorteilhaft ist es, wenn die Träger optisch auslesbar sind und aus einer Blickrichtung von oben auf die Unterlage optisch zugänglich sind. Die optische Zugänglichkeit ist erforderlich, da zur Erstellung des Modellaufbaus die Modelle auf der Unterlage platziert werden. Die Unterlage bildet somit ein Modell des Bodens der Fertigungsstätte, wobei die Auslesung der Träger auf optischem Wege sozusagen aus der Vogelperspektive am besten erfolgen kann, ohne dass sich die Modelle gegenseitig verdecken. Dabei ist eine senkrechte Blickrichtung besonders vorteilhaft. Selbstverständlich können auch hiervon abweichende Blickrichtungen gewählt werden, solange sichergestellt ist, dass sich die Modelle nicht gegenseitig verdecken. Insbesondere bei der Verwendung von zweidimensionalen Modellen, also beispielsweise von Plättchen die lediglich die Umrisse der Fertigungseinrichtungen auf der Unterlage darstellen, kann ein vergleichsweise großer Winkel für die Blickrichtung von beispielsweise 20° bis 90° gewählt werden. Werden dreidimensionale Modelle verwendet, ist ein Winkel für die Blickrichtung von 60° bis 90° vorteilhaft. Der senkrechte Blickwinkel entspricht einem Winkel von 90°. Die Identifikationskennungen können aus eindimensionalen oder zweidimensionalen Strichcodes bestehen. Als Beispiele für einen eindimensionalen Strichcode können der Code 39, der Code 93 oder der Code 128 genannt werden. Als Vertreter zweidimensionaler Strichcodes sind beispielsweise der UR-Code, der DATAMATRIX- oder der AZTEC-Code zu nennen.

Insbesondere, wenn als Einrichtung zum Auslesen der Träger eine Kamera verwendet wird, die einen Bildsensor und ein Objektiv enthält, ist auch zu berücksichtigen, dass eine senkrechte Blickrichtung lediglich im Zentrum des aufgenommenen Bildes gewährleistet ist. An den Bildrändern ergeben sich zwangsläufig Blickrichtungen von oben auf die Unterlage, die von der Senkrechten zur Unterlage abweichen.

Daher ist es vorteilhaft, wenn von dem Modellaufbau mehrere sich überschneidende Bilder aufgenommen werden. Hierdurch ist es möglich, den Blickwinkel in den Bildern durch Verwendung entsprechender Optiken mit längeren Brennweiten gering zu halten und durch Auswertung der Überschneidungen die Vielzahl der Bilder zu einem einzigen Bild zusammenzusetzen. Hierdurch können die Modelle der Fertigungseinrichtungen auf den verschiedenen Bildern zueinander ins Verhältnis gesetzt werden.

Besonders vorteilhaft ist es, wenn sich die Bilder so weit überschneiden, dass jeder Träger mindestens auf zwei Bildern abgebildet ist. Fehler bei der Ermittlung der Position des jeweiligen Modells aufgrund der perspektivischen Verzerrung in den Bildern können dann durch einen Vergleich von mindestens zwei relevanten Bildern korrigiert werden. Relevante Bilder sind diejenigen Bilder, welche den betreffenden Träger abbilden. Dies müssen mindestens zwei Bilder sein. Unter der perspektivischen Verzerrung im Zusammenhang mit dieser Erfindung ist der Umstand zu verstehen, dass ein Bild nur in der optischen Achse des Objektives genau aus der vorgegebenen Blickrichtung, beispielsweise der senkrechten Blickrichtung aufgenommen werden kann. Die Objekte in den Randbereichen des aufgenommenen Bildes haben zwangsläufig eine von dieser bestimmten Blickrichtung abweichende Blickrichtung, die bei der Ermittlung der Position des betreffenden Trägers auf der Unterlage berücksichtigt werden muss. Durch Vergleich der Position des betreffenden Trägers auf einem anderen Bild lässt sich dieser Positionsfehler ermitteln, wobei hierbei der Abstand der Bildachsen der beiden Bilder voneinander Berücksichtigung findet.

Eine besonders vorteilhafte Ausgestaltung des Verfahrens wird erhalten, wenn von dem Modellaufbau mit dem Bildsensor eine zeitliche Folge von digitalen Bildern erstellt wird. Diese zeitliche Folge ergibt sozusagen einen Film, der den intuitiven Planungsprozess durch Verstellen der Modelle darstellt. Die Intervalle zwischen der Erstellung der einzelnen Bilder kann hierbei frei gewählt werden, wobei die einzelnen Bilder einen Vergleich der unterschiedlichen Planungszustände ermöglichen soll. Hierdurch können Änderungen der Positionen der Träger durch einen Vergleich der Bilder ermittelt werden. Die aktualisierten Positionen der Träger können dann über die Identifikationskennungen mit Datensätzen der Fertigungseinrichtungen in dem Planungsprogramm verknüpft werden und das in dem Planungsprogramm verwendete virtuelle Modell der Fertigungsstätte jeweils an das reale Modell angepasst werden.

Vorteilhaft kann mit dem Planungsprogramm ein Ausgabegerät angesteuert werden, auf dem die Änderungen der Position der mit den Trägern verknüpften Fertigungseinrichtungen dargestellt werden. Dies hat den Vorteil, dass bereits während der intuitiven Planungsphase mit dem realen Modell ermittelt werden kann, welche Auswirkungen die vorgeschlagenen (nachgestellten) Änderungen auf das im Planungsprogramm enthaltene virtuelle Modell der Fertigungsstätte haben. Dadurch können auch Aussagen überprüft werden, welche sich nur mit dem Planungsprogramm erstellen lassen. Hierbei können gebräuchliche Planungsprogramme Verwendung finden. Es sind sowohl klassische CAD-Andwendungen denkbar sowie weitere Planungsprogramme wie die z. B. eine Transportmatrix/Sankey-DiagrammDarstellung, eine Anordnungsoptimierung nach Schmigalla, oder eine Nutzwert-Analyse unterstützen.

Besonders vorteilhaft ist es, wenn die bereits erwähnten Korrekturvorschläge des Planungsprogramms auf der flächigen Unterlage dargestellt werden, also derjenigen Unterlage, auf der die Modelle durch den Fabrikplaner verschoben werden. Dies lässt vorteilhaft eine direkte, intuitiv schnell erfassbare Kopplung zwischen dem durch die Modelle repräsentierten Planungsvorschlag der Fabrikplaner und den Korrekturvorschlägen des Planungsprogramms zu. Beispielsweise kann das Planungsprogramm die Umrisse der Modelle in der Position darstellen, wie es der Vorschlag des Planungsprogramms vorsieht. Die Fabrikplaner können sich dann entscheiden, ob sie die Modelle entsprechend dem Vorschlag korrigieren, also auf den Grundriss ziehen, oder eine andere Planungsvariante ausprobieren. In gleicher Weise lassen sich auch die Überlappungen direkt auf der flächigen Unterlage darstellen. Als Ausgabegerät kann beispielsweise ein Projektor (Beamer) verwendet werden, der den Planungsvorschlag von oben auf die flächige Unterlage projiziert. Eine Alternative ist die Ausführung der flächigen Unterlage als Flachbildschirm, so dass die Modelle auf der Bildschirmfläche verschoben werden. Der Bildschirm kann dann gleichzeitig zur Ausgabe des alternativen, durch das Planungsprogramm berechneten Vorschlags verwendet werden.

Das erfindungsgemäße Verfahren wird bei Verwendung von maschinell auslesbaren Trägern folgendermaßen durchgeführt. Die Modelle werden mit maschinell auslesbaren Trägern von Identifikationskennungen versehen. Mit den Modellen wird ein Modellaufbau der Fertigungsanlage auf einer flächigen Unterlage gebildet. Von diesem Modellaufbau wird mit einem Bildsensor aus einer Blickrichtung von oben auf die Unterlage mindestens ein digitales Bild erstellt. Die Identifikationskennungen der Modelle werden maschinell erfasst. Die Positionen der zu den Trägern gehörenden Modelle werden in dem digitalen Bild ermittelt. Und zuletzt werden die Positionen der Modelle über die Identifikationskennungen mit Datensätzen der Fertigungseinrichtungen in dem Planungsprogramm verknüpft.

Vorteilhaft kann vorgesehen werden, dass zusätzlich zu den Identifikationskennungen Lagekennungen auf den Trägern vorgesehen werden, die die Koordinaten der jeweiligen Lage der Träger auf den Modellen enthalten. Es ist dann möglich, die Position der durch die Träger repräsentierten Modelle auf der Unterlage durch Ermittlung der Position der Träger unter Berücksichtigung der Lagekennungen zu berechnen. Im Einzelnen wird dabei folgendermaßen vorgegangen. Die Position des Trägers in dem Bild wird ermittelt. Hierbei können eventuell in der beschriebenen Weise mehrere Bilder ausgewertet werden, um die Position des Trägers zweifelsfrei zu bestimmen. Anschließend wird die Position des Trägers mit den Lagekennungen überlagert, so dass in Abhängigkeit von der Position des Trägers auf die Position des gesamten Modells auf der Unterlage geschlossen werden kann. Dieser Rückschluss erfolgt also durch eine Berechnung des Planungsprogramms, welchem die hierzu notwendigen Informationen in Form von Identifikationskennungen und Lagekennungen zur Verfügung gestellt wird.

Eine alternative Möglichkeit besteht darin, dass die Datensätze der Fertigungseinrichtungen in dem Planungsprogramm die Koordinaten der jeweiligen Lage der Träger auf den Modellen bereits enthalten. In diesem Fall sind keine Lagekennungen auf den Trägern notwendig, da diese Daten bereits im Planungsprogramm abgespeichert wurden. Diese können abgerufen werden, indem die Identifikationskennungen des betreffenden Modells ausgewertet werden und nach Identifikation des Modells die Koordinaten der Lage des Trägers aus dem Datensatz der Fertigungseinrichtung abgerufen werden. Wenn diese zur Verfügung stehen, kann die Position der durch die Träger repräsentierten Modelle auf der Unterlage durch Ermittlung der Position der Träger unter Berücksichtigung der Lage der Träger auf den Modellen berechnet werden.

Eine besondere Variante der Erfindung sieht vor, dass von der aufgestellten Planungsvariante und/oder von den Korrekturvorschlägen die zu erwartenden Kosten und/oder der Flächenbedarf berechnet werden. Hierzu kann das Planungsprogramm vorteilhaft herangezogen werden, so dass von einem Planungsvorschlag zeitnah entscheidungswesentliche Aspekte ermittelt werden können, nämlich welche Kosten mit diesen Planungsvorschlag verbunden sein werden und wie groß der Flächenbedarf insgesamt ist. Auf diese Weise entstehen zusätzliche Kriterien, die den Fabrikplanern bei ihren Entscheidungen unterstützen.

Eine weiterführende Ausführungsform der Erfindung sieht außerdem vor, dass die Datensätze der Fertigungseinrichtungen und/oder die weiteren Datensätze der Beziehung zwischen den Fertigungseinrichtungen mit individuellen Präferenzen ergänzt werden, die den Variantenreichtum der Korrekturvorschläge begrenzen. Hierdurch können individuelle Vorgaben berücksichtigt werden, welche damit den ganzen Planungsprozess beeinflussen und das Auffinden eines diese Präferenzen berücksichtigenden Ergebnisses erleichtern. Das Planungsverfahren lässt sich also vorteilhaft weiter rationalisieren.

Weitere Einzelheiten der Erfindung werden nachfolgend anhand der Zeichnung beschrieben. Gleiche oder sich entsprechende Zeichnungselemente sind in den Figuren jeweils mit den gleichen Bezugszeichen versehen und werden nur insoweit mehrfach erläutert, wie sich Unterschiede zwischen den einzelnen Figuren ergeben. Es zeigen
- Figur 1: die Anwendung eines Ausführungsbeispiels des erfindungsgemäßen Verfahrens in einem Raum schematisch,
- Figur 2: eine räumliche Darstellung eines Ausschnittes eines Ausführungsbeispiels des erfindungsgemäßen Modellaufbaus und
- Figur 3 und 4: Anzeigen am Ausgabegerät bei Anwendung eines Ausführungsbeispiels des erfindungsgemäßen Verfahrens vor und nach der Korrektur der Anordnung der Modelle auf Grund von Überschneidungen.

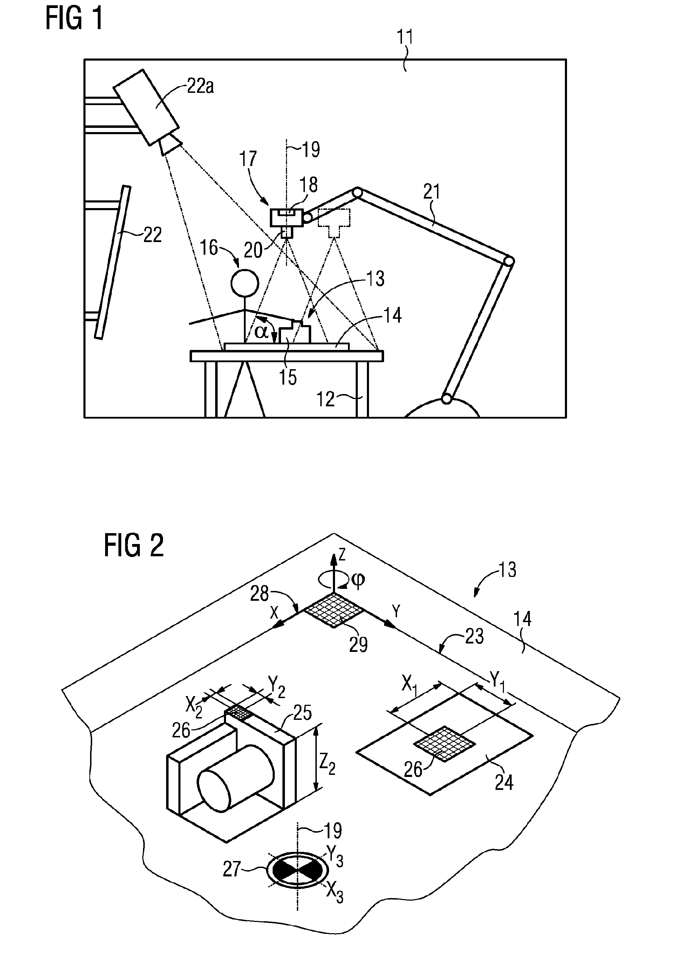

In Figur 1 ist ein Raum 11 dargestellt, in dem das erfindungsgemäße Planungsverfahren durchgeführt werden soll. In der Mitte des Raumes befindet sich ein Tisch 12, auf dem ein Modellaufbau 13 schematisch dargestellt ist. Dieser besteht aus einer Unterlage 14, auf der exemplarisch ein Modell 15 einer Maschine als Fertigungseinrichtung aufgestellt ist. Die Unterlage stellt in nicht dargestellter Weise den Umriss einer Fertigungsstätte in Form einer Werkshalle dar.

Ein erster wesentlicher Verfahrensschritt in dem erfindungsgemäßen Planungsverfahren besteht darin, dass ein Fabrikplaner 16 manuell das Modell 15 an seinen richtigen Platz stellt. Weitere Modelle (nicht dargestellt) und weitere Personen (ebenfalls nicht dargestellt) können sich an dieser Planungsphase beteiligen.

Während dieser Planungsphase nimmt eine Digitalkamera 17 mittels eines Bildsensors 18 in regelmäßigen Zeitabständen Aufnahmen (Bilder) von dem Modellaufbau 13 auf. Dies geschieht von oben, im Ausführungsbeispiel genau in senkrechter Richtung, d. h. der Schwerkraft folgend. Hierdurch entsteht eine Bildachse 19, die senkrecht auf der Unterlage 14 steht. Aufgrund der Brennweite eines Objektivs 20 der Digitalkamera 17 ergibt sicht allerdings für die Modelle am Rand des aufgenommenen Bildes eine Blickrichtung α, die bei ca. 75° zur Unterlage 14 liegt.

Um trotz der perspektivischen Verzerrung infolge unterschiedlicher Betrachtungsrichtungen innerhalb des Bildes die Lage des Modells genau bestimmen zu können, wird mit der Digitalkamera 17 mindestens ein weiteres Bild aus der strichpunktiert dargestellten Position aufgenommen. Zum Bewegen der Kamera ist diese auf einem Stativ 21 befestigt. Alternativ (nicht dargestellt) kann die Kamera auch von dem Fabrikplaner 16 gehalten und manuell ausgerichtet werden, ein Stativ ist in diesem Falle nicht notwendig.

Die Bilddaten der Digitalkamera 17 werden in nicht dargestellter Weise in einem zweiten Planungsschritt von einem Planungsprogramm verarbeitet und in dem Raum 11 mittels eines an der Wand befindlichen Ausgabegerätes 22 in Form eines Bildschirms ausgegeben. Hierdurch ist für den Fabrikplaner 16 ein interaktives Agieren an dem Modellaufbau 13 möglich, wobei Modifikationen an dem durch den Modellaufbau 13 repräsentierten Planungsergebnis sofort an dem Ausgabegerät 22 angezeigt werden, so dass die intuitiv am Modellaufbau 13 erzielten Ergebnisse gleichzeitig einer Analyse durch das Planungsprogramm unterworfen werden können. Auf diese Weise sind kurzfristige Korrekturen möglich, wodurch eine effiziente Optimierung des Planungsergebnisses erfolgen kann.

Das Ausgabegerät 22 ist durch einen Flachbildschirm ausgebildet. Alternativ zu diesem Ausgabegerät kann jedoch auch das Ausgabegerät 22a Verwendung finden. Hierbei handelt es sich um einen Projektor (Beamer), mit dem ein Bildschirminhalt von schräg oben auf die Oberfläche des Tisches 12 geworfen werden kann. Hierbei können bei einer maßstabgetreuen Darstellung Planungsalternativen des Planungsprogramms direkt mit den Modellen 15 auf den Tisch 12 korreliert werden, so dass dem Fabrikplaner 16 ein direkter Vergleich seiner Variante und der durch das Planungsprogramm vorgestellten Variante möglich ist. Durch die Projektionsrichtung von schräg oben muss das durch das Ausgabegerät 22a erzeugte Bild auf der Oberfläche des Tisches entzerrt werden, was allerdings durch gebräuchliche Optiken in dem Ausgabegerät 22a unproblematisch möglich ist. Die schräge Projektionsrichtung ist erforderlich, damit die Kamera 18 in dem projizierten Bild nicht als Schatten sichtbar wird.

Alternativ (nicht in Figur 1 dargestellt) ist es auch möglich, auf eine fest installierte Kamera zu verzichten und die Bilder mit einer Kamera freihändig zu erstellen. In diesem Fall kann der Beamer auch über dem Tisch mit senkrechter Ausrichtung montiert sein.

In Figur 2 ist ein repräsentativer Ausschnitt des Modellaufbaus 13 gemäß Figur 1 dargestellt. Auf der Unterlage 14 ist der Grundriss 23 der zu planenden Fabrikhalle zu erkennen. Auf der Unterlage ist weiterhin ein zweidimensionales Modell 24 und ein dreidimensionales Modell 25 von Fertigungseinrichtungen zu sehen. Hierbei kann es sich beispielsweise um Maschinen, Fertigungszellen oder auch erforderliche Freifläche wie Lagerzonen Pufferzone oder Wege handeln. Die Modelle 24, 25 sind auf bestimmten Stellen der Unterlage platziert und repräsentieren daher einen bestimmten Planungszustand in dem Prozess der Fabrikplanung.

Die Modelle 24, 25 sind mit Trägern 26 von Informationen versehen. Im Ausführungsbeispiel gemäß Figur 2 handelt es sich um Träger optischer Informationen in Form eines zweidimensionalen Strichcodes. Die Informationen beinhalten eine Identifikationskennung für das jeweilige Modell, was auf diesem Wege eindeutig einer zu planenden Fertigungseinrichtung zuzuordnen ist, welche in dem Planungsprogramm mitsamt zusätzlihcer Informationen wie resultierender Flächebedarf, Zugänglichkeit, Sicherheitsvorschriften usw. abgespeichert ist. Weiterhin enthalten Die Träger Informationen über deren Lage auf dem jeweiligen Modell. Im Ausführungsbeispiel gemäß Figur 2 sind diese Lageinformationen beispielsweise in einem karthesischen Koordinatensystem x-y-z wie in Figur 2 eingezeichnet ausgedrückt. Da die Modelle auf der Unterlage auch verdreht werden können, gibt es weiterhin eine Koordinate ϕ, die den Drehwinkel der mit den Modellen verbundenen relativen Koordinatensysteme (nicht dargestellt) gegenüber einem ortsfesten Koordinatensystem 28 der Unterlage um die senkrechte z-Achse ausdrückt.

Bei dem Modell 24 handelt es sich um ein zweidimensionales Modell, so dass in diesem Fall lediglich eine x₁ und eine y₁ Koordinate abgespeichert ist. Das Modell 25 wird als dreidimensionales Modell durch die Koordinaten x₂, y₂, z₂ beschrieben. Hierbei geben die Koordinaten jeweils die Lage des Mittelpunktes des jeweiligen Trägers 26 bezüglich des restlichen Modells an.

Die Winkelkoordinate ϕ kann nicht auf dem Träger abgespeichert werden. Sie muss vielmehr unter Berücksichtigung der Winkelstellung des Modells 24, 25 auf der Unterlage ermittelt werden. Zu diesem Zweck kann der Träger eine Ausrichtungsinformation aufweisen, deren Winkellage durch eine Bildverarbeitung des aufgenommenen Bildes gewonnen wird.

Weiterhin ist auf der Unterlage eine Marke 27 mit den Koordinaten x₃, y₃ zum ortsfesten Koordinatensystem 28 vorgesehen. Diese dient der Ausrichtung der Digitalkamera 17, so dass die Lage der Bildachse 19 bezüglich des ortsfesten Koordinatensystems 28 bekannt ist. Dies erleichtert die räumliche Einordnung der Modelle in dem Planungsprogramm. Zuletzt ist auf der Unterlage auch ein weiterer Träger 29 vorgesehen, der die Lage des ortsfesten Koordinatensystems 28 kennzeichnet.

Die Darstellung der Lagekennungen ist lediglich exemplarisch vorgenommen worden und kann auch auf anderem Wege erfolgen. Insbesondere können die angedeuteten Koordinaten auch in das Planungsprogramm direkt eingegeben werden, so dass eine Hinterlegung auf den Trägern nicht notwenig ist. In diesem Falle wird eine Verknüpfung der Lageinformationen mit den Modellen über die Identifikationskennung im Planungsprogramm vorgenommen.

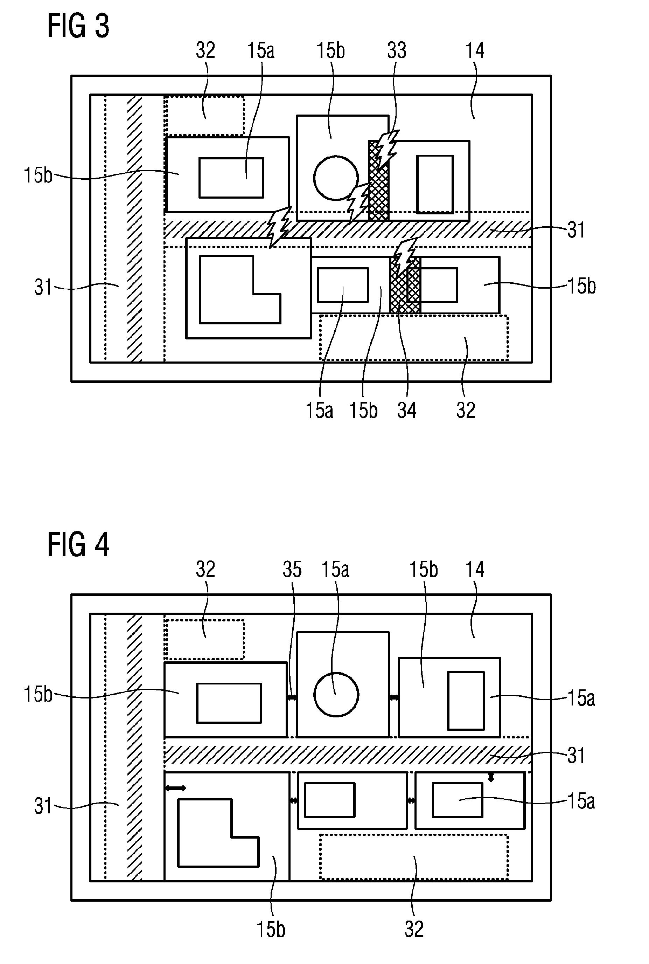

In den Figuren 3 und 4 sind beispielhaft zwei Ausgaben am Ausgabegerät 22 oder 22a dargestellt, wie sie durch ein geeignetes Planungsprogramm generiert werden können. Wenn diese durch das Ausgabegerät 22a ausgegeben werden, erfolgt dies auf der flächigen Unterlage 14, wobei in den Figuren 3 und 4 die realen Modelle weggelassen wurden. Diese werden vielmehr direkt als Umrisse der Fertigungseinrichtungen 15a dargestellt, wobei in der Ausgabe deren realer (körperlicher) Flächenbedarf erkennbar wird. Außerdem ist jeder Fertigungseinrichtung 15a ein relevanter Flächenbedarf 15b zugeordnet, der durch die Vorgaben der jeweiligen Fertigungseinrichtung 15a definiert ist. Weiterhin zeigt die Ausgabe des Planungsprogramms Transportwege 31, welche unbedingt freigehalten werden müssen. Es sind auch Materialbereitstellflächen 32 vorgesehen, die als Pufferzonen für die Zwischenlagerung von Fertigungsgütern (Rohmaterialien, Werkstücke) dienen.

Bei der Ausgabe gemäß Figur 3 handelt es sich zunächst um eine Ausgabe, die lediglich Kollisionen sichtbar machen soll. Dieses wird durch ein Gefahrensymbol 33 in Form eines Blitzes angezeigt. Außerdem entstehen Schnittflächen 34 zwischen den Bereichen des relevanten Flächenbedarfs 15b jeweils benachbarter Fertigungseinrichtungen 15a. Hierdurch kann der Fabrikplaner 16 den Änderungsbedarf schnell erkennen.

Gemäß Figur 4 kann das Planungsprogramm weiterhin einen Korrekturvorschlag machen. Wie in Figur 4 unschwer zu erkennen ist, sind die Gefahren 33 gemäß Figur 3 eliminiert worden, indem die Fertigungseinrichtungen 15a verschoben wurden. Die unterschiedlichen Verschieberichtungen werden in der Ausgabe durch das Planungsprogramm durch kleine Doppelpfeile 35 gekennzeichnet, damit die Korrektur für den Fabrikplaner 16 nachvollziehbar ist.

Auf Grundlage der Ausgabe gemäß Figur 4 kann das Planungsprogramm ohne große Probleme (wegen der maßstabsgerechten Darstellung) die erforderliche Gesamtfläche des Konzeptes errechnen. Die Gesamtfläche setzt sich zusammen aus der Verkehrsfläche, bestehend aus den Transportwegen 31, der Maschinennutzfläche, bestehend aus dem relevanten Flächenbedarf 15b der Fertigungseinrichtungen 15a, der Logistikfläche, bestehend aus der Materialbereitstellungsflächen 32 und der verbleibenden Restfläche. Hieraus können Kennzahlen abgeleitet werden, die eine Bewertung der Planungsalternative ermöglichen.

## Patentansprüche

1. Verfahren zur Eingabe eines räumlichen Aufbaus von Fertigungseinrichtungen, die zusammen eine Fertigungsstätte bilden, in ein rechnergestütztes Planungsprogramm, wobei
• von den Fertigungseinrichtungen reale, zweidimensionale oder dreidimensionale, zumindest hinsichtlich ihres körperlichen Flächenbedarfes maßstabsgerechte Modelle (24, 25) verwendet werden, mit denen ein Modellaufbau der Fertigungsstätte auf einer flächigen Unterlage (14) gebildet wird,
• der Modellaufbau mit einem Sensor, insbesondere einem Bildsensor (18) erfasst wird,
• die Positionen der Modelle (24, 25) auf der Grundlage der durch den Sensor erfassten Daten durch das Planungsprogramm berechnet und mit Datensätzen der Fertigungseinrichtungen in dem Planungsprogramm verknüpft werden,
**dadurch gekennzeichnet, dass**
• die Datensätze der Fertigungseinrichtungen Daten zum über den körperlichen Flächenbedarf hinausgehenden relevanten Flächenbedarf (15b) der Fertigungseinrichtungen aufweisen,
• Überlappungen des jeweiligen relevanten Flächenbedarfs benachbarter Fertigungseinrichtungen ermittelt werden und
• die Überlappungen zwar zugelassen werden, jedoch über ein Ausgabegerät (22) angezeigt werden.

2. Verfahren nach Anspruch 1,
**dadurch gekennzeichnet, dass** die Datensätze der Fertigungseinrichtungen weitere Vorgaben für die Fertigungseinrichtungen, insbesondere Standards und Richtlinien, enthalten.

3. Verfahren nach einem der vorangehenden Ansprüche,
**dadurch gekennzeichnet, dass** weitere Datensätze in dem Planungsprogramm vorgesehen sind, die die Beziehungen der Fertigungseinrichtungen untereinander, insbesondere Stoffflüsse und Transportwege (31), betreffen.

4. Verfahren nach einem der vorangehenden Ansprüche,
**dadurch gekennzeichnet, dass** zusätzliche Datensätze in dem Planungsprogramm vorgesehen sind, die die baulichen Gegebenheiten der Fertigungsstätte betreffen.

5. Verfahren nach einem der vorangehenden Ansprüche,
**dadurch gekennzeichnet, dass**
• das Planungsprogramm einen Korrekturvorschlag zur Vermeidung der ermittelten Überlappungen berechnet und
• der Korrekturvorschlag über das Ausgabegerät (22) angezeigt wird.

6. Verfahren nach Anspruch 5,
**dadurch gekennzeichnet, dass**
• das Planungsprogramm einen Korrekturvorschlag zur Vermeidung von ungenutzten Leerflächen berechnet und
• der Korrekturvorschlag über das Ausgabegerät (22) angezeigt wird.

7. Verfahren nach einem der voranstehenden Ansprüche,
**dadurch gekennzeichnet, dass** das Ausgabegerät (22a) die Überlappungen und/oder Korrekturvorschläge auf der flächigen Unterlage (18) darstellt.

8. Verfahren nach einem der vorangehenden Ansprüche,
**dadurch gekennzeichnet, dass** von der aufgestellten Planungsvariante und/oder von den Korrekturvorschlägen die zu erwartenden Kosten und/oder der Flächenbedarf berechnet werden.

9. Verfahren nach einem der vorangehenden Ansprüche,
**dadurch gekennzeichnet, dass** die Datensätze der Fertigungseinrichtungen und/oder die weiteren Datensatze der Beziehungen zwischen den Fertigungseinrichtungen mit individuellen Präferenzen ergänzt werden, die den Variantenreichtum der Korrekturvorschläge begrenzen.

10. Verfahren nach einem der vorangehenden Ansprüche,
**dadurch gekennzeichnet, dass**
• die Modelle (24, 25) mit maschinell auslesbaren Trägern (26) von Identifikationskennungen versehen werden und
• die Träger (26) optisch auslesbar sind und derart an den Modellen (24, 25) angebracht werden, dass diese aus einer Blickrichtung von oben auf die Unterlage (14) optisch zugänglich sind, nachdem die Modelle (24, 25) auf der Unterlage (14) platziert wurden.

11. Verfahren nach Anspruch 10,
**dadurch gekennzeichnet, dass**
• von dem Modellaufbau mit dem Bildsensor (18) eine zeitliche Folge von digitalen Bildern erstellt wird,
• Änderungen der Positionen der Träger (26) durch einen Vergleich der Bilder ermittelt werden und
• die aktualisierten Positionen der Träger (26) über die Identifikationskennungen mit Datensätzen der Fertigungseinrichtungen in dem Planungsprogramm verknüpft werden.

## Claims

1. Method for inputting a spatial layout of production devices, which together form a production plant, to a computer-aided planning program,
• the production devices using real, two-dimensional or three-dimensional models (24, 25) which are true to scale at least in terms of their physical area requirement and are used to form a model layout of the production plant on a flat substrate (14),
• the model layout being detected using a sensor, in particular an image sensor (18),
• the position of the models (24, 25) being calculated by the planning program on the basis of the data detected by the sensor and being linked to data records of the production devices in the planning program,
**characterized in that**
• the data records of the production devices have data relating to the relevant area requirement (15b) of the production devices which goes beyond the physical area requirement,
• overlaps of the respective relevant area requirement of adjacent production devices are determined, and
• although the overlaps are allowed, they are displayed using an output device (22).

2. Method according to Claim 1,
**characterized in that**
the data records of the production devices contain further specifications for the production devices, in particular standards and guidelines.

3. Method according to one of the preceding claims,
**characterized in that**
further data records are provided in the planning program, which data records relate to the relationships between the production devices, in particular material flows and transport paths (31).

4. Method according to one of the preceding claims,
**characterized in that**
additional data records relating to the structural conditions of the production plant are provided in the planning program.

5. Method according to one of the preceding claims,
**characterized in that**
• the planning program calculates a proposed correction for avoiding the overlaps which have been determined, and
• the proposed correction is displayed using the output device (22).

6. Method according to Claim 5,
**characterized in that**
• the planning program calculates a proposed correction for avoiding unused empty areas, and
• the proposed correction is displayed using the output device (22).

7. Method according to one of the preceding claims,
**characterized in that**
the output device (22a) displays the overlaps and/or proposed corrections on the flat substrate (18).

8. Method according to one of the preceding claims,
**characterized in that**
the expected costs and/or the area requirement is/are calculated from the established planning variant and/or from the proposed corrections.

9. Method according to one of the preceding claims,
**characterized in that**
the data records of the production devices and/or the further data records relating to the relationships between the production devices are supplemented with individual preferences which restrict the wealth of variations of the proposed corrections.

10. Method according to one of the preceding claims,
**characterized in that**
• the models (24, 25) are provided with machine-readable carriers (26) for identification identifiers, and
• the carriers (26) are optically readable and are fitted to the models (24, 25) in such a manner that they are optically accessible from a viewing direction of the substrate (14) from above after the models (24, 25) have been placed on the substrate (14).

11. Method according to Claim 10,
**characterized in that**
• a temporal sequence of digital images is created from the model layout using the image sensor (18),
• changes in the positions of the carriers (26) are determined by comparing the images, and
• the updated positions of the carriers (26) are linked to data records of the production devices in the planning program using the identification identifiers.

## Revendications

1. Procédé d'introduction d'une configuration spatiale de dispositifs de fabrication, qui forment ensemble un lieu de fabrication, dans un programme de planification assisté par ordinateur, dans lequel
• des dispositifs de fabrication, on utilise des modèles (24, 25) réels bidimensionnels ou tridimensionnels à l'échelle, au moins en ce qui concerne leur besoin de surface matériel, avec lesquels on forme une configuration de modèle du lieu de fabrication sur un support (14) en deux dimensions,
• on détecte la configuration du modèle par un capteur, notamment par un capteur (18) d'images,
• on calcule par le programme de planification les positions des modèles (24, 25) sur la base des données détectées par le capteur et on les combine dans le programme de planification à des jeux de données des dispositifs de fabrication,
**caractérisé en ce que**
• les jeux de données des dispositifs de fabrication comportent des données sur le besoin (15b) de surface des dispositifs de fabrication pertinent allant au-delà du besoin de surface matériel,
• on détermine des chevauchements du besoin de surface pertinent respectivement de dispositifs de fabrication voisins et
• on autorise certes les chevauchements, mais on les affiche par un appareil (22) d'émission.

2. Procédé suivant la revendication 1,
**caractérisé**
**en ce que** les jeux de données des dispositifs de fabrication contiennent d'autres prescriptions pour les dispositifs de fabrication, notamment des normes et des directives.

3. Procédé suivant l'une des revendications précédentes,
**caractérisé**
**en ce qu'**il est prévu, dans le programme de planification, d'autres jeux de données, qui concernent les relations des dispositifs de fabrication entre eux, notamment les flux de matières et les voies (31) de transport.

4. Procédé suivant l'une des revendications précédentes,
**caractérisé**
**en ce qu'**il est prévu, dans le programme de planification, des jeux de données supplémentaires, qui concernent les données de construction du lieu de fabrication.

5. Procédé suivant l'une des revendications précédentes,
**caractérisé en ce que**
• le programme de planification calcule une proposition de correction pour empêcher les chevauchements déterminés et
• on affiche la proposition de correction par l'appareil (22) d'émission.

6. Procédé suivant la revendication 5,
**caractérisé en ce que**
• le programme de planification calcule une proposition de correction pour empêcher des surfaces vides inutilisées et
• on affiche la proposition de correction par l'appareil (22) d'émission.

7. Procédé suivant l'une des revendications précédentes,
**caractérisé**
**en ce que** l'appareil (22a) d'émission représente les chevauchements et/ou les propositions de correction sur le support (18) en deux dimensions.

8. Procédé suivant l'une des revendications précédentes,
**caractérisé**
**en ce qu'**à partir de la variante de planification établie et/ou des propositions de correction, on calcule les coûts escomptés et/ou le besoin de place.

9. Procédé suivant l'une des revendications précédentes,
**caractérisé**
**en ce que** l'on complète les jeux de données des dispositifs de fabrication et/ou les autres jeux de données des relations entre les dispositifs de fabrication par des préférences individuelles qui limitent l'abondance des variantes des propositions de correction.

10. Procédé suivant l'une des revendications précédentes,
**caractérisé en ce que**
• on munit les modèles (24, 25) de supports (26) de caractérisation d'identification, pouvant être exploités par une machine et
• on exploite optiquement les supports (26) et on les met sur les modèles (24, 25), de manière à ce que ceux-ci soient accessibles visuellement par le haut sur le support (14) dans une direction de visualisation, après que les modèles (24, 25) ont été placés sur le support (14).

11. Procédé suivant la revendication 10,
**caractérisé en ce que**
• à partir de la configuration du modèle, on produit, par le capteur (18) d'images, une succession dans le temps d'images numériques,
• on détermine des variations des positions des supports (26) par une comparaison des images et
• on combine, dans le programme de planification, les positions mises à jour des supports (26) par les caractérisations d'identification à des jeux de données des dispositifs de fabrication.
